# FASCICULE DE BREVET EUROPEEN

(11) **EP 2 197 780 B1**
(45) Date de publication et mention de la délivrance du brevet: **02.02.2011**
(21) Numéro de dépôt: 08869876.6
(22) Date de dépôt: 09.10.2008
(51) Int. Cl.: B81B 7/00, B81C 1/00, H01L 23/26, H01J 7/18

(54) **STRUCTURE COMPORTANT UNE COUCHE GETTER ET UNE SOUS-COUCHE D'AJUSTEMENT ET PROCÉDÉ DE FABRICATION**
STRUKTUR MIT EINER GETTER-SCHICHT UND EINER UNTERSCHICHT ZUR EINSTELLUNG SOWIE VERFAHREN ZU IHRER HERSTELLUNG
STRUCTURE COMPRISING A GETTER LAYER AND AN ADJUSTMENT SUBLAYER, AND FABRICATION PROCESS

(30) Priorité: 15.10.2007 FR 0707212
(43) Date de publication de la demande: 23.06.2010
(60) Demande divisionnaire: 10158202.1
(73) Titulaire: Commissariat à l'Énergie Atomique et aux Énergies Alternatives, 75015 Paris (FR)
(72) Inventeur: BAILLIN, Xavier, F-38920 Crolles (FR)
(74) Mandataire: de Jong, Jean Jacques
(86) Numéro de dépôt international: PCT/FR2008/001420
(87) Numéro de publication internationale: WO 2009/087284

(56) Documents cités:
- WO-A-03/028096
- US-A- 4 127 134
- US-A- 6 110 808
- US-B1- 6 423 575

## Description

### Domaine technique de l'invention

L'invention est relative à une structure comportant une cavité fermée sous atmosphère contrôlée dans laquelle sont disposés au moins un dispositif et un getter comportant au moins une couche getter, la cavité étant délimitée par un substrat et un capot de fermeture.

### État de la technique

L'intégration sous vide permet à de nombreux dispositifs, par exemple microélectroniques, tels que les systèmes micro électro mécaniques (MEMS ou « Micro Electro Mechanical Systems » en anglais) d'améliorer leurs performances. Cependant, l'utilisation d'une encapsulation sous vide engendre de nombreux problèmes, et notamment la tenue dans le temps du niveau du vide et la qualité de l'atmosphère encapsulée.

Dans cette voie, les matériaux getters non-évaporables (N.E.G. ou « Non Evaporable Getter » en anglais) déposés en couches minces ont fait l'objet de nombreuses publications. Ces matériaux réagissent et capturent de nombreux gaz avec lesquels ils sont au contact par formation d'un oxyde, d'un hydrure ou alors par simple adsorption de surface. De cette manière, la désorption des matériaux délimitant une cavité sous vide est compensée par la couche en matériau getter qui adsorbe et/ou absorbe les éléments désorbés des autres matériaux.

L'intégration de matériaux getters non-évaporables au sein d'une structure d'encapsulation a notamment été décrite dans le brevet US6923625. Ce brevet décrit l'utilisation, sur un substrat, d'un getter comportant une couche réactive recouverte par une couche de protection. Dans ce document, la couche de protection empêche la couche réactive de réagir avec l'environnement extérieur à température ambiante. La couche réactive du getter n'agit qu'à partir de sa température d'activation, température à partir de laquelle les atomes de la couche réactive diffusent à travers la couche de protection et absorbent une partie des gaz de l'environnement extérieur. La température d'activation est une caractéristique intrinsèque du matériau getter.

D'une façon générale, les getters connus mono ou multicouches ont une capacité d'absorption ou d'adsorption qui est limitée à une plage de température déterminée. Dans le domaine des microsystèmes, il est avantageux de pouvoir disposer d'un matériau getter adaptable aux contraintes imposées par les procédés technologiques indispensables à la réalisation du dispositif. Les contraintes peuvent être thermiques, il faut alors obtenir l'adéquation entre la température d'activation du matériau getter et le procédé de formation d'une cavité fermée par scellement, par exemple de deux substrats sur un joint. Par ailleurs, le matériau getter doit être en mesure de supporter les ambiances gazeuses qui sont utilisées lors de la formation du dispositif tout en étant réactif lors de l'utilisation du dispositif dans sa cavité fermée.

Le document WO 03/028096 décrit la réalisation, sur un substrat, d'un getter en film mince qui est constitué par un film en palladium déposé sur un film en titane. Le film getter en titane est formé sur une couche de blindage électromagnétique en aluminium ou en cuivre.

Le document US6110808 divulgue un boîtier qui comporte une cavité fermée sous atmosphère contrôlée. Dans la cavité est disposé un getter qui est constitué par plusieurs couches getter élémentaires en palladium, en titane et en nickel. La couche de surface en palladium attrape l'hydrogène moléculaire.

### Objet de l'invention

L'invention a pour but une structure dans laquelle le getter présente une capacité de pompage optimale dans une plage de température désirée.

Selon l'invention, ce but est atteint par le fait qu'une sous-couche d'ajustement de la température d'activation de la couche getter est située entre la couche getter et le substrat et/ou le capot de fermeture sur laquelle elle est formée et en ce que la couche getter est constituée par une pluralité de couches getter élémentaires selon la revendication 1.

L'invention a également pour objet un procédé de réalisation d'une telle structure.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente en vue schématique, en coupe, une structure selon l'art antérieur,
- les figures 2 et 3 représentent, en vue schématique, en coupe, des structures selon l'invention,
- la figure 4 représente, en vue schématique, en coupe, l'empilement d'un getter multicouche d'une structure selon l'invention.

### Description de modes de réalisation préférentiels de l'invention

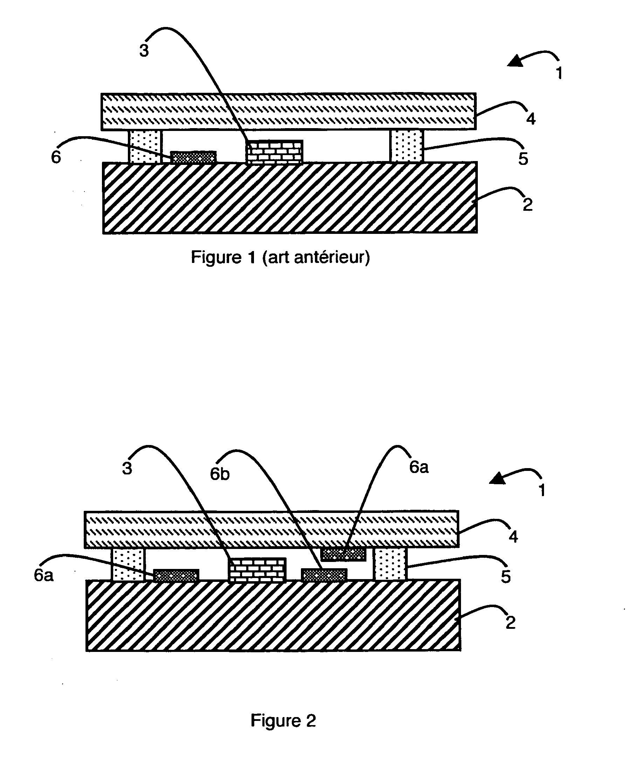

Comme illustré sur la figure 2, une structure 1 pouvant être une puce microélectronique comporte classiquement au moins un dispositif 3, par exemple de type microélectronique, disposé dans une cavité étanche délimitée par deux substrats 2 et 4 et par un joint de scellement 5 périphérique fermé. L'étanchéité de la cavité est assurée par le joint de scellements 5 situé entre les substrats et qui entoure le dispositif 3. Le dispositif microélectronique 3 est, par exemple, formé sur le premier substrat 2. La cavité est généralement en dépression par rapport à l'atmosphère extérieure, de préférence sous vide ou sous une pression contrôlée d'azote ou d'argon.

Classiquement, la hauteur de la cavité est définie par la hauteur du joint de scellement 5 qui entoure le dispositif 3 (figure 1). Cependant, le second substrat 4 peut être structuré de manière à former un capot comportant une partie centrale plus mince, de manière à augmenter le volume de la cavité.

Le second substrat 4 est, par exemple, en silicium, en silicium oxydé ou nitruré ou en verre. Le premier substrat 2 est, par exemple, en silicium ou tout autre matériau semi-conducteur, à l'exception de l'arséniure de gallium (GaAs), ou alors en un autre matériau sur lequel un dispositif déjà formé peut être intégré.

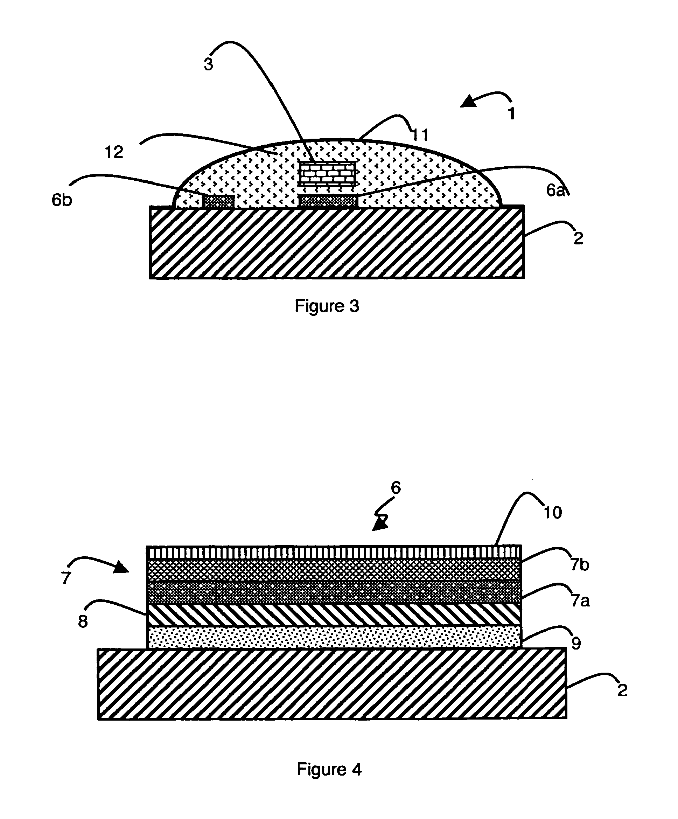

Dans un autre mode de réalisation, illustré à la figure 3, la structure 1 comporte une cavité fermée et étanche qui est délimitée par le substrat 3 et par une couche d'encapsulation 11. L'étanchéité de la structure est alors assurée par l'adhérence entre la couche d'encapsulation 11 et le substrat 2. La couche d'encapsulation joue alors le rôle d'un capot de fermeture comme le substrat 4 de la figure 1. Le capot de fermeture peut comporter d'autres couches en plus de la couche d'encapsulation. Dans le mode de réalisation illustré à la figure 3, la hauteur de la cavité est définie par l'épaisseur d'un matériau sacrificiel 12 déposé sur le substrat.

Afin d'assurer la pérennité du niveau de la dépression et/ou de la qualité de l'atmosphère à l'intérieur de la cavité, la cavité comporte au moins un getter 6, sur au moins une de ses parois internes. Le getter 6 est de type multicouche et comporte au moins une sous-couche d'ajustement 8 située entre un des substrats, 2 ou 4 et une couche getter 7 qui constitue classiquement la couche adsorbante et/ou absorbante. La couche getter 7 est, par exemple, en matériau métallique choisi, de préférence, de manière à avoir une forte capacité de pompage de l'azote, ce gaz étant couramment utilisé lors de l'encapsulation des dispositifs. Si les getters 6 présentent, entre eux, différentes températures d'activation, il est avantageux de les distinguer par exemple en getters 6a et getters additionnels 6b (figures 3 et 4) ou en premier 6a et second 6b getters.

A titre d'exemple, sur la figure 4, le getter 6 est formé sur le substrat 2. Une sous-couche d'accroche 9 est avantageusement déposée sur le substrat 2 avant la sous-couche d'ajustement 8. La sous-couche d'accroche 9 est destinée à permettre une meilleure adhérence de la sous-couche d'ajustement 8 sur le substrat 2. Pour un substrat de silicium, la sous-couche d'accroche 9 est typiquement réalisée, par toute technique adaptée, par exemple en titane ou zirconium et présente une épaisseur avantageusement comprise entre 20 et 100 nm.

La sous-couche d'ajustement 8, située sous et en contact avec la couche getter 7, est destinée à permettre de moduler la température d'activation de la couche getter, c'est-à-dire de moduler la température à laquelle la couche getter réagit avec l'atmosphère présente à l'intérieur de la cavité. La sous-couche d'ajustement 8 est, de préférence, en Cu, Ni, Pt, Ag, Ru, Cr, Au, Al et présente une épaisseur comprise, de préférence, entre 50 et 500 nm lorsque l'épaisseur de la couche getter 7a est de l'ordre de plusieurs centaines de nanomètres, typiquement entre 100 et 2000nm. L'épaisseur de la sous-couche d'ajustement peut être réduite à quelques dizaines de nanomètres, typiquement entre 10 et 90nm, lorsque la couche getter 7a est de quelques centaines de nanomètres, typiquement entre 100 et 900nm. A titre d'exemple, une sous-couche d'ajustement 8 de 30nm est suffisante pour une couche getter 7a de 300nm. L'épaisseur minimale de la sous-couche d'ajustement 8 est approximativement entre 5% et 10% de l'épaisseur de la couche getter 7a, par exemple égale à 8%. Plus généralement, la sous-couche d'ajustement 8 est, par exemple, en un matériau métallique, à l'exception du palladium, déposé à l'état de corps pur qui comme le platine, par exemple, est chimiquement neutre vis-à-vis de la couche getter 7 dans le domaine d'activation recherché. La sous-couche d'ajustement 8 peut aussi être en un matériau qui devient neutre ou qui devient un piège pour certaines espèces chimiques, par exemple l'oxygène, après interaction avec la couche getter 7. C'est notamment le cas du cuivre ou du nickel, qui sont susceptibles de former un composé intermétallique de type Ti₂Cu ou Ti₂Ni avec une couche getter en titane, composé dans lequel l'oxygène est partiellement soluble. La sous-couche d'ajustement 8 peut aussi être en un matériau qui a une forte affinité chimique pour l'un ou plusieurs éléments chimiques parmi le carbone, l'oxygène et l'azote. La sous-couche peut, par exemple, être en chrome ou en aluminium. Dans ce dernier cas, la sous-couche 8 en aluminium sert de protection à la couche getter 7 lorsqu'elle est exposée à l'air ambiant, accroissant ainsi le temps de stockage du getter sans altération de ses propriétés, car la sous-couche 8 évite la croissance d'une couche d'oxyde. Cette architecture est particulièrement avantageuse pour obtenir des capacités de pompage constantes après une exposition à l'air ambiant de plusieurs mois.

En présence d'une sous-couche d'aluminium, le getter est directement actif sans pré-traitement préalable à son utilisation. La température d'activation d'un empilement getter constituées par une sous-couche d'ajustement 8 en aluminium et une couche getter 7a en titane est de l'ordre de 400°C.

De plus, dans un mode de réalisation particulier, une couche de protection 10 peut être disposée sur la couche getter 7 pour protéger le getter. Ainsi, le getter 6 peut maintenir sa capacité de pompage après une exposition prolongée à l'air ambiant ou être protégé de procédés technologiques agressifs qui pourraient le dégrader. Par exemple, si une sous-couche d'ajustement 8 en aluminium permet de conserver le getter 6 à l'air ambiant, une fine couche de chrome agissant en tant que couche de protection 10 peut être utilisée sur la couche getter 7. L'épaisseur de la couche de protection 10, par exemple en chrome, peut être comprise entre 10 et 50nm, et avantageusement égale à 20nm. L'ajout d'une couche de protection 10 contribue à augmenter légèrement la température d'activation du getter, typiquement une vingtaine de degrés Celsius pour une couche de 20nm en Chrome.

Dans un autre mode de réalisation, si le getter est altéré en surface soit par l'oxydation produite lors du stockage à l'air ambiant soit par des procédés technologiques agressifs auxquels il est exposé pendant la réalisation des structures, un pré-traitement de régénération peut facilement être mis en oeuvre. Le pré-traitement de régénération consiste à exposer le getter sous un vide secondaire, avantageusement à une pression de l'ordre de 10⁻⁷mbar ou sous une pression partielle d'un gaz neutre non absorbé par le getter et à une température proche de sa température d'activation pendant une durée qui lui permet d'absorber la couche qui dégrade sa capacité de pompage. Le getter est ensuite refroidi jusqu'à la température ambiante, typiquement une température proche de 20°C. Dans un mode de réalisation privilégié qui peut être combiné, par exemple, avec le mode de réalisation précédent, avant son exposition à l'air ambiant, le getter est exposé à un gaz connu, de préférence de l'azote, qui va s'adsorber en surface et protéger ainsi temporairement le getter vis-à-vis de l'air ambiant. A titre d'exemple, une température de 350°C est appliquée pendant quelques heures pour régénérer l'ensemble des getters 6a décrits dans la présente invention.

Il peut être avantageux d'ajouter, par exemple, dans l'enceinte de traitement thermique sous vide, des getters sacrificiels déposés sur la surface entière d'un substrat. Le getter sacrificiel est choisi pour avoir une température d'activation inférieure à celle du getter 6 (ou des getters 6a, 6b) qui doit être traité lors du pré-traitement de régénération. Le getter sacrificiel sert alors à améliorer la qualité du vide dans l'enceinte. Avant traitement des getters, il peut être avantageux de purger l'enceinte avec un gaz neutre tel que l'argon afin de limiter les pressions partielles des gaz résiduels susceptibles de réagir avec le getter. Les getters peuvent ainsi être soumis à des atmosphères oxydantes avec lesquelles ils réagissent puis être régénérés comme décrit ci-dessus.

Typiquement, ces atmosphères oxydantes sont générées lors d'étapes technologiques, notamment les étapes d'élimination d'une couche sacrificielle en résine polymère. De manière classique, lors de la réalisation d'une structure illustrée à la figure 3, le matériau getter 7 est soumis à de telles atmosphères oxydantes. En effet, le getter 6a et le dispositif 3 sont encapsulés par une résine sacrificielle 12 puis par une couche d'encapsulation 11. La résine sacrificielle est mise en forme, par exemple, par chauffage avant le dépôt de la couche d'encapsulation 11. Le dispositif et le getter sont libérés de la couche de résine sacrificielle 12 à partir d'orifices réalisés dans la couche d'encapsulation 11. A titre d'exemple, la résine sacrificielle 12 peut être une résine standard de polarité positive utilisée en photolithographie et/ou une résine de polarité négative de type polyimide. Ces résines peuvent être, toutes les deux, détruites avec un traitement thermique dans une atmosphère oxydante. Il est alors particulièrement intéressant de choisir un getter 6 composé d'au moins une sous-couche d'ajustement 8 et au moins une couche getter 7 tel que la température d'activation soit supérieure à la température de la cuisson de la résine sacrificielle. De cette manière, on évite de polluer le getter par les contaminants issus du polymère et ainsi de réduire, voire annuler sa capacité de pompage.

Ce mode de réalisation est particulièrement avantageux pour la fabrication des MEMS et des détecteurs Infra-Rouge afin de brûler les couches de résines sur lesquelles sont construits des éléments du microdispositif et sa couche d'encapsulation.

Les matériaux getters sont généralement exposés à un traitement par voie sèche généralement oxydant en vue d'améliorer la propension du substrat sur lequel est déposé le getter au scellement direct. Ce traitement contribue ainsi à augmenter l'énergie d'adhésion entre les deux substrats qui délimitent la cavité lors de leur mise en contact. Afin de limiter l'effet du traitement oxydant, une couche de protection 10 en chrome est alors recommandée. Le choix d'un getter 6a à base température d'activation, avantageusement inférieure à 300°C, permet à la fois de consolider le scellement et d'activer le getter à une température proche de 400°C. Ainsi, le getter est activé lors du traitement de consolidation du scellement entre les deux substrats.

La sous-couche d'ajustement 8 a, de préférence, un coefficient de dilatation thermique compris sensiblement entre 5.10⁻⁶/°C et 20.10⁻⁶/°C, voire 23.10⁻⁶/°C pour l'aluminium et un rapport entre sa température d'élaboration Te et sa température de fusion Tf (en kelvin) compris sensiblement entre 0,1 et 0,3. La température d'activation, de la couche getter 7 associée, est alors une fonction croissante du coefficient de dilatation, de la sous-couche d'ajustement 8 et du rapport Te/Tf et varie de façon décroissante avec la température de fusion de la sous-couche d'ajustement 8. Il est connu que le coefficient de dilatation des métaux diminue lorsque la température de fusion dudit métal augmente. Sur une gamme de température limitée, il est possible de déterminer, de manière empirique, l'équation qui lie la température d'activation du getter 6 et la température de fusion du métal qui constitue la sous-couche d'activation 8. Notamment pour les métaux suivants Ru, Cr, Pt, Ni, Au, Cu, Ag, et Al, l'équation reliant la température d'activation Ta du getter à la température de fusion Tf du matériau constituant la sous-couche d'ajustement est : Ta = -0,0727.Tf + 447, dans laquelle Ta et Tf sont exprimées en degrés Celsius. Dans ce cas de figure, le dépôt est réalisé à une température proche de la température ambiante sur un substrat en silicium. Bien que cette équation n'est aucun sens physique, elle permet de rendre compte du phénomène.

L'effet de la sous-couche d'ajustement 8 sur la couche getter 7 peut être interprété de la manière suivante. L'effet getter dans un matériau métallique déposé en couche mince se produit par diffusion des espèces chimiques adsorbées vers l'intérieur de la couche. L'effet getter est donc relié à la microstructure, c'est-à-dire à la taille, à la forme et à l'orientation des grains qui composent le matériau métallique. L'absorption des espèces chimiques depuis la surface vers l'intérieur du getter se produit par diffusion le long des joints de grains. Ce qui correspond à un phénomène thermiquement activé qui se produit à relativement basse température, comparativement à une diffusion des espèces dans les grains. Les structures les plus aptes à présenter un effet getter sont donc celles pour lesquelles les grains sont colonnaires et de petite taille, favorisant ainsi la diffusion aux joints de grains. Il est par ailleurs connu que la structure du dépôt dépend en grande partie du rapport entre la température du substrat, c'est-à-dire la température d'élaboration (Te), sur lequel est déposé le métal et la température de fusion de ce dernier (Tf), soit le rapport Te/Tf (en degrés Kelvin). Les diagrammes de Movchan et Demchisin (B.A. Movchan, A.V. Demchishin, 1969, Phys. Met. Metallogr., 28, p.83) d'une part et de Thornton (J.A. Thornton, 1986 , J. Vac. Sci. Technol., A4(6), p.3059) d'autre part fournissent une cartographie prévisionnelle de la microstructure en fonction du rapport Te/Tf et de la pression. Il apparaît d'après ces diagrammes que la zone où la structure du dépôt est de type colonnaire commence à partir de 0.3Tf (Tf en Kelvin). Pour Movchan et Demchisin, en deçà de cette valeur, la structure est en forme de dômes séparés par des vides intercolonnaires, au-delà de 0.5Tf la structure devient plus isotrope et équiaxe. Entre 0.3Tf et 0.5Tf les grains colonnaires grossissent. C'est la mobilité de surface des atomes, limitée à basse température, qui permet d'expliquer les structures obtenues dans ces conditions. Les températures qui définissent les transitions entre les différents types de structure (0.3Tf et 0.5Tf) sont approximatives et servent de guide, mais elles doivent, en toute rigueur, être définies de façon empirique pour chaque métal.

De ce fait, si différentes sous-couches d'ajustement 8 sont réalisées avec des métaux différents, mais dans les mêmes conditions de température (Te) et de pression, la taille de grains augmente lorsque le rapport Te/Tf croît. Pour une même température d'élaboration Te, une sous-couche en ruthénium va donc présenter une microstructure plus fine, donc plus de joints de grains, qu'une sous-couche en aluminium. La croissance de la couche getter 7 sur la sous-couche 8 est en partie contrôlée par la mobilité des atomes de matériau getter en surface de la sous-couche d'ajustement 8. Une sous-couche 8 en ruthénium pourrait de par sa microstructure (germination préférentielle de la couche getter 7 aux joints de grains, noeuds triples ou entre les dômes de la structure sous-jacente) et/ou sa température de fusion élevée limiter la migration en surface du métal getter et ainsi conduire à une structure de celui-ci plus fine que dans le cas opposé ou la couche getter 7 est déposée sur de l'aluminium.

Selon ce raisonnement, il est donc possible pour une même sous-couche d'ajustement 8, de moduler la température d'activation Ta de la couche getter 7. Il suffit d'ajuster la microstructure de la sous-couche d'ajustement 8 en fonction de sa température d'élaboration Te, tout en restant dans un domaine de température qui va permettre de conférer à la sous-couche d'ajustement une structure suffisamment fine pour que le getter soit activable par un procédé de diffusion majoritairement aux joints de grains.

Dans les structures qui comportent des getters 6 qui ont entre eux des températures d'activation différentes, les getters 6 peuvent être divisés en au moins des getters 6a et des getters additionnels 6b. Dans ce cas de figure, il n'est pas obligatoire que le getter comporte une couche getter 7 constituée par au moins deux couches élémentaires 7a et 7b. Un tel exemple ne fait pas partie de la présente invention.

Ainsi, pour une structure qui comporte au moins un getter 6a et un getter additionnel 6b à l'intérieur d'une cavité fermée, il est possible de réaliser, simplement et de manière industrielle, au moins un getter 6a et un getter additionnel 6b ayant des températures d'activation différentes. La sous-couche d'ajustement du getter 6a présente, par exemple, une structure de grains supérieure à la partie de la sous-couche d'ajustement du getter additionnel 6b. En d'autres termes, les grains de la sous-couche d'ajustement 8 du getter 6a sont plus gros que les grains de la sous-couche d'ajustement 8 du getter additionnel 6b. De ce fait, la couche getter déposée simultanément sur les deux sous-couche d'ajustement présente une microstructure cristalline plus fine dans le getter additionnel 6b que dans le getter 6a. Il est donc possible d'obtenir deux getters 6a et 6b ayant deux températures d'activation différentes en utilisant le même matériau pour les sous-couches d'ajustement des deux getters 6a et 6b, mais en prenant soin d'élaborer les deux sous-couches à des températures différentes. Les deux getters 6a et 6b ont donc deux températures d'activation différentes, que les matériaux constituants les couches getter 7 soient identiques ou non pour les deux getters.

II est également possible d'obtenir deux getters 6a et 6b ayant deux températures d'activation différentes en utilisant le même matériau pour la couche getter et deux matériaux différents en ce qui concerne la sous-couche d'ajustement.

Il s'agit d'un avantage technologique supplémentaire, puisqu'il devient possible avec une même nature de sous-couche d'ajustement de contrôler la température d'activation du getter. Il est aussi envisageable de réaliser plusieurs sous-couches d'ajustement sur un même substrat par des opérations successives de dépôt, photolithographie et gravure. La couche getter 7 et éventuellement la couche de protection 10, sont ensuite déposées successivement et mises en forme par photolithographie et gravure. La couche getter 7 et éventuellement la couche de protection 10 peuvent être alors identiques pour tous les getters.

La sous-couche d'ajustement 8 étant située entre la couche getter et le substrat 2, elle permet également d'éliminer les interactions chimiques entre le substrat 2 et la couche getter 7. Ainsi, la capacité de pompage de la couche getter 7 est préservée.

Dans un exemple qui ne fait pas partie de la présente invention, la couche getter 7 déposée sur la sous-couche d'ajustement 8 est en Ti ou Zr et présente une épaisseur comprise entre 100 et 2000 nm. La température d'activation de la couche getter, sans l'action de la sous-couche d'ajustement 8, est supérieure à 425°C et proche de 450°C. Avec l'action de la sous-couche d'ajustement 8, la température d'activation de la couche getter 7 varie selon la nature de cette sous-couche d'ajustement 8. La température d'activation de la couche getter 7, en titane ou en zirconium, peut varier de manière croissante sensiblement entre 275 et 425°C suivant la sous-couche d'ajustement 8.

Le tableau suivant (tableau 1) donne, à titre d'exemple, quelques valeurs de température d'activation d'un getter 6 en fonction de la nature de sa sous-couche d'ajustement 8, pour une couche getter 7 en titane. L'ensemble des dépôts est réalisé par évaporation sur un substrat en silicium à une température d'élaboration Te identique, proche de la température ambiante.

| Nature de la sous-couche d'ajustement 8 | Température d'activation |
|---|---|
| Ru | 275°C |
| Cr | 300°C |
| Pt | 325°C |
| Ni | 350°C |
| Au | 365°C |
| Cu | 375°C |
| Ag | 380°C |
| Al | 400°C |

Compte tenu du fait que la température de fusion du zirconium est plus élevée que celle du titane, la microstructure du dépôt de zirconium doit être plus fine que celle du titane. Les températures d'activation présentées dans le tableau 1 devraient donc être sensiblement plus basses avec une sous-couche getter en zirconium qu'avec une couche getter en titane.

La couche getter 7 est selon l'invention constituée par l'empilement d'une pluralité de couches getter élémentaires, de préférence deux, 7a, 7b, de compositions chimiques différentes. Les couches getter élémentaires sont déposées l'une au-dessus de l'autre sur la sous-couche d'ajustement 8. Dans le cas où deux couches getter élémentaire 7a, 7b sont utilisées, la première couche getter élémentaire 7a, en contact avec la sous-couche d'ajustement 8, présente une température d'activation supérieure à celle de la deuxième couche getter élémentaire 7b qui la recouvre. Ainsi, les couches getter élémentaires 7a, 7b, présentent une température d'activation décroissante au fur et à mesure qu'elles s'éloignent de la sous-couche d'ajustement 8. Ainsi, lorsque la deuxième couche getter 7b est saturée, un traitement thermique à la température d'activation de la première couche getter élémentaire 7a permet de régénérer la deuxième couche getter élémentaire 7b. Il est donc possible d'ajuster la température d'activation de la première couche getter élémentaire 7a au moyen de la sous-couche d'ajustement 8 pour obtenir la température d'activation souhaitée, compte tenu de la température d'activation de la deuxième couche getter élémentaire 7b.

La première couche getter élémentaire 7a, en contact avec la sous-couche d'ajustement 8, est de préférence en titane et a une épaisseur comprise, de préférence, entre 100 et 1000nm. La deuxième couche getter élémentaire 7b, déposée sur la couche getter élémentaire 7a, est alors, par exemple, en zirconium et a une épaisseur comprise, de préférence, entre 200nm et 1000nm.

L'utilisation de deux couches getter élémentaires 7a, 7b différentes est particulièrement avantageuse pour reconditionner la puce au cours de sa durée de vie par activation de la première couche 7a.

De plus, la sous-couche d'ajustement 8 du getter multicouche peut être choisie de façon à accroître la réflectivité du getter au rayonnement infrarouge, typiquement lorsque le getter est choisi réflecteur au rayonnement infrarouge (pour certaines applications spécifiques). Cette fonction réflectrice est avantageusement choisie, en fonction notamment de la nature du matériau de la sous-couche d'ajustement 8 qui est avantageusement en cuivre ou en aluminium. Par exemple dans un bolomètre, cette réflectivité est suffisante pour placer le getter en tant que réflecteur IR. Dans ce cas, le getter 6 présente une autre fonction essentielle : réflecteur IR. Si la couche est en titane, elle possède déjà une certaine réflectivité au rayonnement infrarouge. L'utilisation d'une sous-couche d'ajustement adaptée permet alors d'augmenter la réflectivité au rayonnement infrarouge à l'ensemble du getter.

Le getter multicouche 6 comportant au moins, la sous-couche d'ajustement 8, la couche getter 7 et éventuellement la sous-couche d'accroche 9 peut être réalisé n'importe où dans la cavité et par exemple sur le substrat 2 ou 4 avant ou après formation du dispositif microélectronique 3. Un tel getter 6 peut également être formé sur les deux substrats 2 et 4 délimitant la cavité.

La sous-couche d'accroche 9 est avantageusement déposée par toute technique adaptée, de préférence par évaporation sur le substrat 2. La sous-couche d'ajustement 8 puis les première et deuxième couches getter élémentaires (7a, 7b) sont ensuite déposées successivement, avantageusement par évaporation, sur la sous-couche d'accroche 9. Avantageusement, les dépôts des différentes couches sont réalisés au sein du même équipement de dépôt. La sous-couche d'accroche 9 peut contribuer à améliorer la qualité du vide dans cette enceinte de dépôt, lorsque le matériau formant cette couche (par exemple Ti ou Zr) a des propriétés getters.

Ensuite, le getter 6 peut être structuré de manière classique, par exemple par lithographie et gravure par voie sèche, avantageusement par un plasma non réactif et/ou par voie humide, de manière à localiser de manière précise les zones dans lesquelles les couches getter 7 sont désirées. L'adhérence de la résine positive utilisée pour la lithographie sur la couche getter 7, peut être améliorée, si nécessaire, par l'apport d'un promoteur d'adhérence, avantageusement l'hexaméthyldisilazane (HDMS).

Les couches 7, 8, 9 et 10 sont gravées à partir de réactifs chimiques liquides usuels et/ou par un plasma neutre en fonction des matériaux utilisés. Avantageusement, on peut graver les couches getter 7 et de protection 10 par voie humide et le reste de l'empilement par plasma neutre lorsque la gravure humide de la sous-couche d'ajustement n'est pas aisée, par exemple pour le platine et le ruthénium. On peut aussi utiliser les deux modes de gravure lorsqu'il y a incompatibilité entre les réactifs de gravure des différentes couches. Cette incompatibilité peut conduire à des phénomènes de sur-gravure voire d'altération de certaines couches.

L'étape de retrait de la résine positive et éventuellement de tout ou partie du promoteur peut être réalisée par un produit classique utilisé dans l'industrie de la microélectronique et avantageusement suivi d'un nettoyage à l'acide nitrique fumant, lorsque celui-ci n'affecte pas la sous-couche 8. Au final, une gravure sèche avec un plasma non réactif permet, si nécessaire, d'éliminer des polluants ou résidus provenant d'étapes technologiques précédentes et présents en surface de la couche getter 7.

Le getter peut être également structuré lors du dépôt par un procédé de décollement (lift-off en anglais). Un film sec photosensible de polarité négative est laminé sur le substrat. Le film sec d'une épaisseur comprise entre 5 et 50µm, avantageusement égale à 15µm, est insolé et développé suivant une étape conventionnelle de photolithographie. L'ensemble est ensuite soumis à un traitement sous vide secondaire visant à éliminer les résidus du développement. Le dépôt du getter est ensuite réalisé, par exemple, par pulvérisation, avantageusement par évaporation. Le retrait du film sec non exposé est réalisé au moyen d'un produit spécifique, qui ne modifie pas les propriétés du matériau getter.

Au moyen des procédés de réalisation décrits ci-dessus, il est possible de réaliser successivement plusieurs getters 6, présentant des températures d'activation différentes sur un même substrat et/ou dans une même cavité. Dans le cas où la structuration du getter 6 est réalisée par gravure chimique, il est avantageux de déposer et structurer les différentes sous-couches d'ajustement 8 des différents getters. La couche getter 7 est ensuite déposée, puis structurée par gravure chimique. La couche d'ajustement 8 et la couche getter 7 n'étant pas réalisées immédiatement à la suite et dans le même équipement, il est préférable d'utiliser un pré-traitement de régénération comme décrit ci-dessus.

Dans le cas où la structuration du getter 6 est réalisée par décollement, il est possible de réaliser des dépôts successifs de getters 6, en laminant un film sec sur un getter déjà formé. Il est alors possible d'ajuster, dans une même structure, la température d'activation de plusieurs getters différents.

La surface du getter pouvant être ajustée, la capacité de pompage de chaque getter en termes de nombre de moles adsorbées ou absorbées peut être contrôlée ce qui permet de moduler la pression à l'intérieure de la cavité qui contient les getters.

## Revendications

1. Structure comportant une cavité fermée sous atmosphère contrôlée dans laquelle sont disposés au moins un dispositif (3) et un getter (6a) comportant au moins une couche getter (7), la cavité étant délimitée par un substrat et un capot de fermeture, structure **caractérisée en ce qu'**une sous-couche d'ajustement (8) de la température d'activation de la couche getter (7) est située entre la couche getter (7) et le substrat (2) et/ou le capot de fermeture (4, 11) sur laquelle elle est formée et **en ce que** la couche getter (7) est constituée par une pluralité de couches getter élémentaires (7a, 7b), de compositions différentes disposées au-dessus de la sous-couche d'ajustement (8) et **en ce que** les couches getter élémentaires (7a, 7b), disposées sur la sous-couche d'ajustement, présentent une température d'activation décroissante au fur et à mesure qu'elles s'éloignent de la sous-couche d'ajustement (8).

2. Structure selon la revendication 1, **caractérisée en ce que** le matériau de la sous-couche d'ajustement (8) est métallique et choisi parmi Ru, Cr, Pt, Nl, Nl, Cu, Al, Al, Ag et Au.

3. Structure selon la revendication 2, **caractérisée en ce que** le coefficient de dilatation thermique de la sous-couche d'ajustement (8) est compris entre 5.10⁻⁶/°C et 23.10⁻⁸/°C.

4. Structure selon l'une quelconque des revendications 1 à 3, **caractérisée en ce qu'**une sous-couche d'accroche (9) choisie parmi le titane et le zirconium est disposée entre la sous-couche d'ajustement (B) et le substrat et/ou le capot correspondant.

5. Structure selon l'une quelconque des revendications 1 à 4, **caractérisée en ce que** l'épaisseur de la sous-couche d'ajustement (8) est comprise sensiblement entre 50 et 500nm.

6. Structure selon l'une quelconque des revendications 1 à 5, **caractérisée en ce que** le matériau de chaque couche getter élémentaire (7a, 7b) est métallique et choisi parmi le titane et le zirconium.

7. Structure selon l'une quelconque des revendications 1 à 6, **caractérisée en ce que** l'épaisseur de la couche getter (7) est comprise sensiblement entre 100 et 2000nm.

8. Structure selon l'une quelconque des revendications 1 à 7, **caractérisée en ce qu'**elle comporte au moins un getter additionnel (6b) ayant une température d'activation différente du getter (6a).

9. Structure selon la revendication 8, **caractérisée en ce que** les matériaux des sous-couches d'ajustement (8) du getter (6a) et du getter additionnel (6b) sont identiques.

10. Structure selon la revendication 8, **caractérisée en ce que** les matériaux des couches getter (7) du getter (6a) et du getter additionnel (6b) sont Identiques.

11. Procédé de réalisation d'une structure selon l'une quelconque des revendications 1 à 10, **caractérisé en ce qu'**il comporte les dépôts successifs, sur un substrat et/ou un capot, de la sous-couche d'ajustement (8) et des couches getter élémentaires (7a, 7b), la structuration desdites couches et un nettoyage de la surface externe de la couche getter élémentaire supérieure (7b).

12. Procédé selon la revendication 11, **caractérisé en ce que** le rapport entre la température d'élaboration et la température de fusion de la sous-couche d'ajustement (8) est compris sensiblement entre 0,1 et 0,3.

13. Procédé selon l'une des revendications 11 et 12, **caractérisé en ce qu'**il comporte une étape de pré-traitement d'une surface externe de la couche getter (7).

14. Procédé selon la revendication 13, **caractérisé en ce que** l'étape de pré-traitement comporte un traitement thermique sous un vide secondaire.

15. Procédé selon l'une quelconque des revendications 11 à 14, **caractérisé en ce qu'**il comporte la formation d'un getter sacrificiel ayant une température d'activation inférieure à celle du getter (6a).

## Claims

1. Structure comprising a closed cavity under a controlled atmosphere wherein there are arranged at least a device (3) and a getter (6a) comprising at least one getter layer (7), the cavity being delineated by a substrate and a sealing cover, structure **characterized in that** an adjustment sub-layer (8) of the activation temperature of the getter layer (7) is situated between the getter layer (7) and the substrate (2) and/or the sealing cover (4, 11), whereon it is formed, and that the getter layer (7) is formed by a plurality of elementary getter layers (7a, 7b) of different compositions arranged above the adjustment sub-layer (8), and that the elementary getter layers (7a, 7b), arranged on the adjustment sub-layer, present an activation température decreasing with the distance from the adjustment sub-layer (8).

2. Structure according to claim 1, **characterized in that** the material of the adjustment sub-layer (8) is metallic and is chosen from Ru, Cr, Pt, Ni, Cu, Al, Ag and Au.

3. Structure according to claim 2, **characterized in that** the coefficient of thermal expansion of the adjustment sub-layer (8) is comprised between 5*10⁻⁶/°C and 23*10⁻⁶/°C.

4. Structure according to any one of the claims 1 to 3, **characterized in that** an adhesion sub-layer (9) chosen from titanium and zirconium is arranged between the adjustment sub-layer (8) and the corresponding substrate and/or cover.

5. Structure according to any one of the claims 1 to 4, **characterized in that** the thickness of the adjustment sub-layer (8) is substantially comprised between 50 and 500nm.

6. Structure according to any one of the claims 1 to 5, **characterized in that** the material of each elementary getter layer (7a, 7b) is metallic and chosen from titanium and zirconium.

7. Structure according to any one of the claims 1 to 6, **characterized in that** the thickness of the getter layer (7) is comprised substantially between 100 and 2000nm.

8. Structure according to any one of the claims 1 to 7, **characterized in that** it comprises at least an additional getter (6b) having a different activation temperature of the getter (6a).

9. Structure according to claim 8, **characterized in that** the materials of the adjustment sub-layers (8) of the getter (6a) and of the additional getter (6b) are identical.

10. Structure according to claim 8, **characterized in** than the materials of the getter layers (7) of the getter (6a) and of the additional getter (6b) are identical.

11. Method for fabricating a structure according to any one of claims 1 to 10, **characterized in that** it comprises successive deposition of the adjustment sub-layer (8) and of the elementary getter layers (7a, 7b) on a substrate and/or a cover, patterning of said layers and cleaning of the external surface of the top elementary getter layer (7b).

12. Method according to claim 11, **characterized in that** the ratio between the formation temperature and the melting temperature of the adjustment sub-layer (8) is comprised substantially between 0.1 and 0.3.

13. Method according to one of claims 11 and 12, **characterized in that** it comprises a pre-treatment step of an external surface of the getter layer (7).

14. Method according to claim 13, **characterized in that** the pre-treatment step comprises a heat treatment in a secondary vacuum.

15. Method according to any one of claims 11 to 14, **characterized in that** it comprises formation of a sacrificial getter having a lower activation temperature than that of the getter (6a).

## Patentansprüche

1. Struktur, die einen geschlossenen Hohlraum unter kontrollierter Atmosphäre umfasst, in der mindestens eine Vorrichtung (3) und ein Getter (6a) angeordnet sind, die mindestens eine Getterschicht (7) umfassen, wobei der Hohlraum von einem Substrat und einer Abdeckkappe begrenzt wird, Struktur, die **dadurch gekennzeichnet ist, dass** eine Unterschicht (8) zur Anpassung der Aktivierungstemperatur der Getterschicht (7) zwischen der Getterschicht (7) und dem Substrat (2) und/oder der Abdeckkappe (4, 11) angeordnet ist, auf der sie gebildet ist, sowie **dadurch**, dass die Getterschicht (7) von einer Mehrzahl elementarer Getterschichten (7a, 7b) unterschiedlicher Zusammensetzungen gebildet wird, die über der Anpassungs-Unterschicht (8) angeordnet sind, und **dadurch**, dass die elementaren Getterschichten (7a, 7b), die auf der Anpassungsunterschicht angeordnet sind, eine Aktivierungstemperatur haben, die mit deren zunehmender Entfernung von der Anpassungs-Unterschicht (8) abnimmt.

2. Struktur nach Anspruch 1, **dadurch gekennzeichnet, dass** das Material der Anpassungsunterschicht (8) aus Metall ist und aus Ru, Cr, Pt, Ni, Cu, Al, Ag und Au ausgewählt ist.

3. Struktur nach Anspruch 2, **dadurch gekennzeichnet, dass** der Wärmeausdehnungs-Koeffizient der Anpassungs-Unterschicht (8) 5,10⁻⁶ bis 23,10⁻⁶/°C beträgt.

4. Struktur nach einem der Ansprüche 1 bis 3, **dadurch gekennzeichnet, dass** zwischen der Anpassungs-Unterschicht (8) und dem Substrat und/oder der jeweiligen Abdeckkappe eine Unter-Verankerungsschicht (9) angeordnet ist, die aus Titan und Zirkonium ausgewählt ist.

5. Struktur nach einem der Ansprüche 1 bis 4, **dadurch gekennzeichnet, dass** die Dicke der Anpassungs-Unterschicht (8) im Wesentlichen 50 bis 500 nm beträgt.

6. Struktur nach einem der Ansprüche 1 bis 5, **dadurch gekennzeichnet, dass** das Material jeder elementaren Getterschicht (7a, 7b) Metall ist und aus Titan und Zirkonium ausgewählt ist.

7. Struktur nach einem der Ansprüche 1 bis 6, **dadurch gekennzeichnet, dass** die Dicke der Getterschicht (7) im Wesentlichen 100 bis 2000 nm beträgt.

8. Struktur nach einem der Ansprüche 1 bis 7, **dadurch gekennzeichnet**, das sie mindestens einen zusätzlichen Getter (6b) mit einer anderen Aktivierungstemperatur als derjenigen des Getters (6a) umfasst.

9. Struktur nach Anspruch 8, **dadurch gekennzeichnet, dass** die Materialien der Anpassungs-Unterschichten (8) des Getters (6a) und des zusätzlichen Getters (6b) identisch sind.

10. Struktur nach Anspruch 8, **dadurch gekennzeichnet, dass** die Materialien der Getterschichten (7) des Getters (6a) und des zusätzlichen Getters (6b) identisch sind.

11. Verfahren zur Herstellung einer Struktur nach einem der Ansprüche 1 bis 10, **dadurch gekennzeichnet, dass** es das aufeinanderfolgende Abscheiden der Anpassungs-Unterschicht (8) und der elementaren Getterschichten (7a, 7b) auf einem Substrat und/oder einer Abdeckkappe, eine Strukturierung der genannten Schichten und eine Reinigung der Außenfläche der oberen elementaren Getterschicht (7b) umfasst.

12. Verfahren nach Anspruch 11, **dadurch gekennzeichnet, dass** das Verhältnis zwischen der Herstellungs- und der Schmelztemperatur der Anpassungs-Unterschicht (8) im Wesentlichen 0,1 bis 0,3 beträgt.

13. Verfahren nach einem der Ansprüche 11 und 12, **dadurch gekennzeichnet, dass** es einen Schritt zur Vorbehandlung einer Außenfläche der Getterschicht (7) umfasst.

14. Verfahren nach Anspruch 13, **dadurch gekennzeichnet, dass** der Vorbehandlungsschritt eine Wärmebehandlung unter Sekundärvakuum umfasst.

15. Verfahren nach einem der Ansprüche 11 bis 14, **dadurch gekennzeichnet, dass** es die Bildung eines Opfergetters mit einer Aktivierungstemperatur umfasst, die unter derjenigen des Getters (6a) liegt.
